# EUROPEAN PATENT APPLICATION

(11) **EP 1 939 690 A1**
(43) Date of publication of application: **02.07.2008**
(21) Application number: 08005292.1
(22) Date of filing: 08.12.2003
(51) Int. Cl.: G03F 7/20

(54) **Lithographic apparatus and device manufacturing method**

(30) Priority: 13.12.2002 EP 02258605
(62) Divisional of application: 03257692.8
(71) Applicant: ASML Netherlands B.V., 5504 DR Veldhoven (NL)
(72) Inventor: Van Beek, Michael Cornelis, 5646 HX Eindhoven (NL); Bakker, Levinus Pieter, 5708 ZT Helmond (NL); Bisschops, Theodorus Hubertus Josephus, 5616 GG Eindhoven (NL); Jonkers, Jeroen, 52062 Aachen (DE); Kroon, Mark, 3531 VB Utrecht (NL); Wolters, Robertus Adrianus Maria, 5644 LA Eindhoven (NL); Maas, Adrianus Johannes Henricus, 5611 CX Eindhoven (NL)
(74) Representative: Leeming, John Gerard

(57) **Abstract**

The use of a downstream radical source 10 to produce a beam 7 of radicals for cleaning contaminants from a surface 8.

## Description

The present invention relates to a lithographic projection apparatus that can comprise:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context Generally, the said pattern will correspond to a particular functional layer in a device being created in the target portion, such as an integrated circuit or other device (see below). Examples of such patterning means include:
- A mask The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

Contamination on the surface of elements, such as optical elements like reflectors, lenses, deflectors, sensors or the patterning means, degrades the performance of the apparatus. This is especially true for apparatus employing EUV radiation, which is especially sensitive to intensity loss, but is also a problem for Deep UV (DUV), electron (EPL) and ion projection lithography (IPL). Contamination may, for example, follow from hydrocarbon contaminants in the apparatus being deposited on the surfaces. Radiation (especially EUV radiation) incident on the surface breaks the bonds of the hydrocarbons to form chemical bonds between carbon atoms from the hydrocarbons and the surface, leaving an amorphous carbon layer. The hydrocarbons themselves can also degrade the performance of the apparatus. Other contaminants include O₂ and H₂O and crystals of refractory compounds, including those that contain sulfates, phosphates or silanes. An amorphous carbon layer, for example, absorbs a significant fraction of the EUV radiation subsequently incident on an optical surface (approximately 1% in a I nm thick layer, for example). Therefore, for an apparatus with ten reflectors, (which even when perfectly clean, are not efficient reflectors), each with such an amorphous carbon layer formed on their surface, the intensity of the EUV beam at the substrate will be reduced by a further 10%. This in turn increases the required exposure time for each substrate and reduces the throughput of the apparatus.

For sensors, the absorption of the EUV radiation prohibits calibrated dose measurements and reduces the signal-to-noise ratio. For instance, sensors are required to accurately measure the intensity of EUV radiation in an EUV apparatus in order to ensure that the required exposure dose is provided to a substrate. It is therefore necessary for the contamination to be removed without damaging the sensitive diode.

Under the normal conditions of an EUV apparatus, the carbon growth rate is approximately 1 - 10 nm/hr. Therefore, for example, the optical elements require regular cleaning. For the cleaning to be practical, it must be performed in-situ, be quick and must not damage the optical surface.

A presently known method of removing the carbon contamination combines UV radiation and ozone to react with the carbon to form CO and CO₂ which desorb from a surface and are subsequently pumped away. However, for efficient UV/ozone cleaning, a pressure of at least 1 mbar is required. This is not compatible with an EUV lithographic apparatus in which the pressure is approximately 10⁻⁷ to 10⁻² mbar. Furthermore, the cleaning rate for UV/ozone cleaning is approximately 1 to 10 nm/hr. This is approximately the same as the rate of contamination. Therefore 50% of the operational time would be required for cleaning. This loss of throughput is not acceptable in practical terms.

An alternative well-known cleaning method is conventional oxygen plasma cleaning. Again, oxygen radicals react with the carbon to form CO and CO₂ molecules which desorb from the surface and can subsequently be pumped away. However, conventional oxygen plasma cleaning is also unsuitable for use in an EUV lithographic apparatus. To generate a stable plasma, again requires a pressure of approximately 1 mbar. A plasma is also difficult to confine to a specific region and, if used in a lithographic apparatus, may damage other sensitive elements of the apparatus such as the electronics and cables.

It is an object of the present invention to provide a method of cleaning surfaces in a lithographic projection apparatus that overcomes the disadvantages described above.

This and other objects may be achieved according to the invention in a lithographic apparatus as specified in the opening paragraph, characterized in that the apparatus further comprises:
- a downstream radical source, connected to a gas supply, providing a beam of radicals; and
- means for directing said beam of radicals onto a surface to be cleaned.

Such apparatus can quickly and effectively remove contamination. Furthermore, because the volume where the radicals are formed is separated from the rest of the lithographic tool, the conditions in this region can be optimized without affecting the remainder of the . apparatus. For example, the downstream radical source may provide a local region of high pressure to sustain a stable plasma to produce the radicals without needing the pressure within the remainder of the lithographic apparatus to be raised above the normal operating pressure of 10⁻⁷ to 10⁻² mbar. Additionally radical source can be located away from the lithographic apparatus in which very little space is available.

In order to reduce the risk of damage to a surface, preferably the beam of radicals contains substantially no ionized particles. This is achieved by the ionized particles produced in the radical source being neutralized by collisions with the walls of the downstream radical source and/or a Faraday grid at the orifice of the downstream radical source. Most of the neutral radicals survive such collisions and exit the downstream radical source to react with the contaminant.

The gas supply may supply one of oxygen, hydrogen and fluorine such that the downstream radical source produces oxygen, hydrogen or fluorine radicals. Different radicals may be used to remove different contaminants. For example, oxygen radicals may be used to remove amorphous carbon, hydrocarbon molecules and polymerized hydrocarbons, whereas oxides may be removed with hydrogen or fluorine radicals.

An optical surface to be cleaned may be one of the patterning means, a sensor, a lens, a deflector and a reflector for reflecting one of the projection beam and the patterned beam. Contamination on any one of these surfaces will reduce the efficiency and/or the accuracy of the apparatus.

The position of the downstream radical source may be fixed. In this case, the means for directing the beam of radicals onto the surfaces to be cleaned will incorporate a means for moving the component, containing the surface to be cleaned, such that the beam of radicals is incident on the surface. Many of the components that require cleaning must, in any case, be movable within the apparatus. Consequently this arrangement will be simpler than providing a means for moving the downstream radical source to the components to be cleaned. Alternatively or additionally, the downstream radical source may be moved to and/or over the surfaces to be cleaned.

Especially in the case of an apparatus employing EUV radiation, the apparatus may comprise an evacuated chamber containing the patterning means, the substrate and the projection system. The evacuated chamber may also contain the end of a tube which is part of the downstream radical source and from which the beam of radicals is discharged. The remainder of the downstream radical source, including an RF coil or a microwave or RF cavity that generates a region of plasma within the tube and through which gas from the gas supply flows to produce the radicals may be located outside of the evacuated chamber. This reduces the number of components that must be made vacuum compatible and reduces the required size of the evacuated chamber. This in turn minimizes the cost of the apparatus. The radicals may also be formed, for example, by the provision of a high temperature element in the flow of gas. The high temperature element should be hot enough to cause thermal dissociations. As with the RF coil or a microwave or RF cavity, the high temperature element may be provided outside the evacuated chamber.

Where several surfaces must be cleaned or the surface to be cleaned is large, the apparatus may comprise two or more downstream radical sources and corresponding beams of radicals that may simultaneously be generated, reducing the total cleaning time and increasing the throughput of the apparatus.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
characterized by
- providing a flow of gas in a downstream radical source to produce a beam of radicals; and
- directing said beam of radicals onto a surface to be cleaned.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a downstream radical source according to an embodiment of the present invention;
Figure 3 depicts a variant of the downstream radical source shown in Figure 2;
Figure 4 depicts a further variant of the downstream radical source shown in Figure 2;
Figure 5 depicts a further variant of the downstream radical source shown in Figure 2;
Figure 6 depicts a variant of the downstream radical source shown in Figure 4;
Figure 7 depicts a variant of the downstream radical source shown in Figure 5;
Figure 8 depicts a variant of the downstream radical source shown in Figure 7; and
Figure 9 depicts a variant of the downstream radical source shown in Figure 8.

In the Figures, corresponding reference symbols indicate corresponding parts.

### Embodiment 1

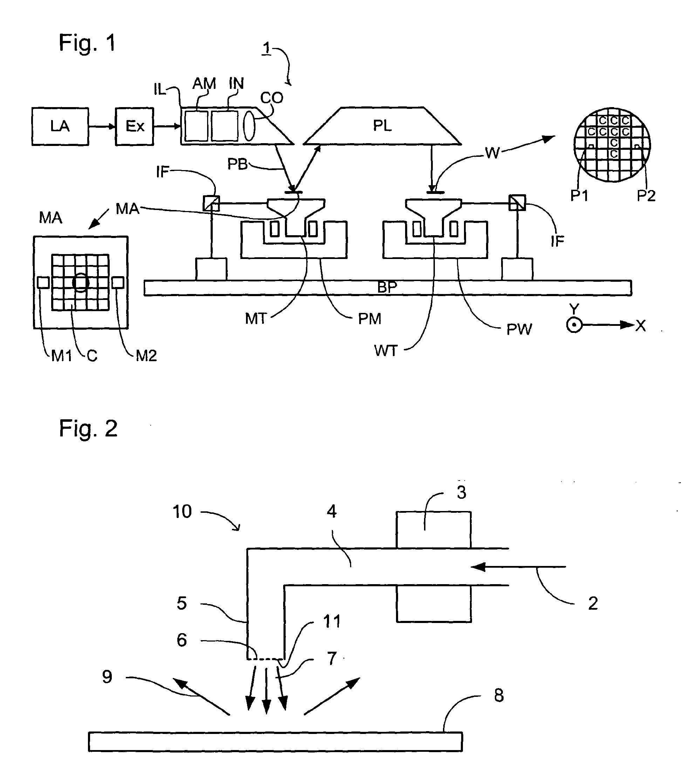

Figure 1 schematically depicts a lithographic projection apparatus according to a particular embodiment of the invention. The apparatus may comprise:
- a radiation system Ex, IL, for supplying a projection beam PB of radiation (*e.g.* EUV radiation), which in this particular case also comprises a radiation source LA;
- a first object table (mask table) MT provided with a mask holder for holding a mask MA (*e.g.* a reticle), and connected to first positioning means for accurately positioning the mask with respect to item PL;
- a second object table (substrate table) WT provided with a substrate holder for holding a substrate W (*e.g.* a resist-coated silicon wafer), and connected to second positioning means for accurately positioning the substrate with respect to item PL;
- a projection system ("lens") PL (*e.g.* mirror group) for imaging an irradiated portion of the mask MA onto a target portion C (*e.g.* comprising one or more dies) of the substrate W.

As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass at least both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However; in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. the substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv,* in which *M* is the magnification of the lens PL (typically, *M* = 1/4 or 1/5). In this manner, a relatively large target portion C can be exposed, without having to compromise on resolution.

Figure 2 shows a downstream radical source 10 usable in the present invention. A flow of oxygen 2 or other gas, such as hydrogen or fluorine is provided to flow through a tube 5. The oxygen flows through a plasma region 3 which may be generated, for example, by an RF coil or a microwave or RF cavity. Other means of generating the plasma region will also be suitable. Alternatively, the radicals may be created in a continuous or burst mode DC discharge. In the plasma region 3, neutral and ionized active particles are generated The ionized particles may be neutralized by collisions with the tube walls 5 or with a Faraday grid 6 that may be located at, for example, the tube orifice. The neutral radicals, which will react with a contaminant, such as carbon, but will not damage the surface, survive these collisions and exit the tube as beam 7. The neutral radicals react with, for example, a carbon contaminant on the optical surface 8 to form CO and CO₂ 9 which desorb from the surface and disperse into the lithographic apparatus. In the case of apparatus employing EUV radiation, the CO and CO₂ gas is subsequently extracted by a vacuum system.

Although it is desirable to remove the ionized particles from the beam 7 to reduce the likelihood of damage to the surface 8, it will be appreciated that the present invention can be performed with a beam 7 that contains ionized particles. In any case, the Faraday grid 6 is not an essential feature of the invention and, where appropriate, the ionized particles may be removed by other means.

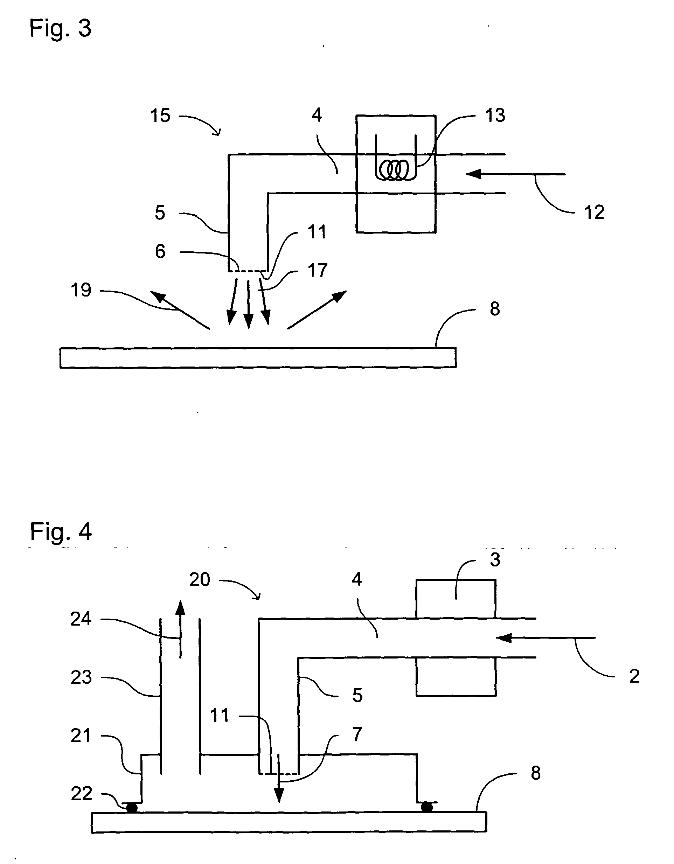

Figure 3 shows a variant 15 of the apparatus shown in Figure 2. In this case, the radicals are generated by a high temperature element 13 such as a glowing wire. The heating element should be at a high enough temperature, for example 1700°C, for efficient thermal dissociation. This apparatus and method is especially useful for generating a beam of hydrogen radicals 17 from a flow of hydrogen gas 12. Hydrogen radicals are especially useful for removing oxides, in which case, the radicals react to form H₂O.

The downstream radical source 10 may be fixed within the lithographic apparatus and the elements requiring cleaning will be moved to be within the path of the beam 7 of neutral radicals. Depending on the size of the area to be cleaned, the optical element may be scanned repeatedly under the beam 7. Entire surfaces of the optical element may be cleaned or, alternatively, the surfaces may be pre-scanned to determine which specific areas require cleaning and then these areas scanned under the beam 7. Alternatively, the lithographic apparatus may have a downstream radical source that can be moved to a surface that requires cleaning and/or moved to scan the beam of radicals over a surface to be cleaned. A combination of both systems may also be used.

In a preferred embodiment, only the end of the tube 5 of the downstream radical source that incorporates the opening 11 from which the beam 7 of radicals is discharged will be located in the evacuated chamber containing the elements to be cleaned (e.g. in the case of apparatus using EUV radiation). However, where appropriate, the entirety of the downstream radical source may be contained within the evacuated chamber.

During normal use of an EUV lithographic apparatus, the surfaces of the sensors on the wafer stage will require cleaning approximately every 10 minutes. The time taken to clean the sensors will be less than about one minute. Therefore the reduction in throughput due to this form of cleaning will be within acceptable limits. The cleaning cycle of other elements will be comparable or better.

Although the above description has only specified a single downstream radical source within an apparatus, it will be appreciated that the total cleaning time required may be reduced by providing two or more downstream radical sources within the apparatus.

Figure 4 shows a downstream radical source 20 which is a further variant of that shown in Figure 2. In this case a hood 21 is attached to the end of the tube 5 to minimize the flow of gas into the remainder of the apparatus. This is especially useful for apparatus using EUV radiation, in which the patterning means, the projection system and the substrate may be within an evacuated chamber. A seal 22 is provided around the edge of the hood 21 that is in contact with the surface 8 to be cleaned. A second tube 23 attached to the hood 21 is used to exhaust the gases 24, such as CO and CO₂, from the hood. This apparatus can, for example, also be used in a chamber that is at a higher pressure in which case the hood 21 can be used to create a region of lower pressure for the downstream radical source to operate in.

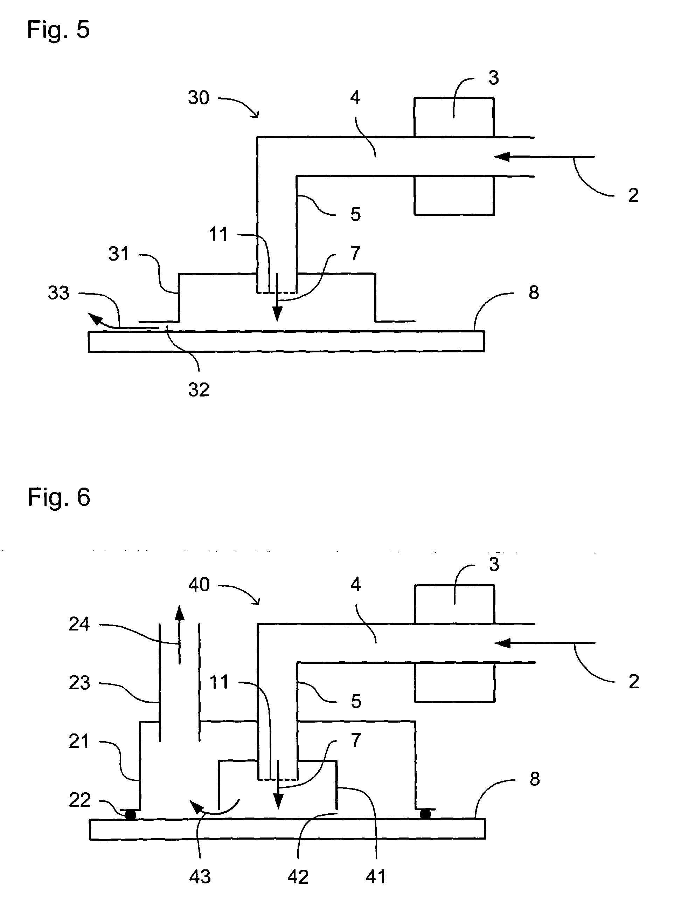

Figure 5 shows a further variant 30 of the downstream radical source of the present invention. Again a hood 31 is attached to the end of the tube 5 of the downstream radical source. In many cases the surface 8 of the element to be cleaned will be too sensitive to have contact with the hood. Therefore the hood 31 is closely positioned adjacent to the surface 8, leaving a small, controlled, gap 32 between the edge of the hood 31 and the surface 8. The gap can be accurately servo-controlled, for example, by using capacitor sensors. Gas 33, such as CO and CO₂, will flow from within the hood 31 into the evacuated chamber. However, because the gas will flow through a restricted space, the pressure within the hood 31 will be greater than that in the evacuated chamber. This will assist in maintaining sufficient pressure within the downstream plasma radical source to form a stable plasma region 3, for example.

Figure 6 shows a further variant of the invention. As with the variant shown in Figure 4, the downstream radical source 40 has a hood 21 that connects to the surface 8 to be cleaned by means of a seal 22 to minimize the flow of gas from the hood 21 into the evacuated chamber. A second hood 41 is provided within the first hood 21. A narrow gap 42 is left between the second hood 41 and the surface 8 to be cleaned. The gas 43, such as CO and CO₂, flows through this narrow gap 42 into the space between the first and second hoods 21, 41. This establishes a pressure difference between the inside of the second hood 41 and the space between the first hood and the second hood. This in turn increases the pressure difference between the evacuated chamber and the gas in the tube 5 which facilitates the formation of a stable plasma region 3.

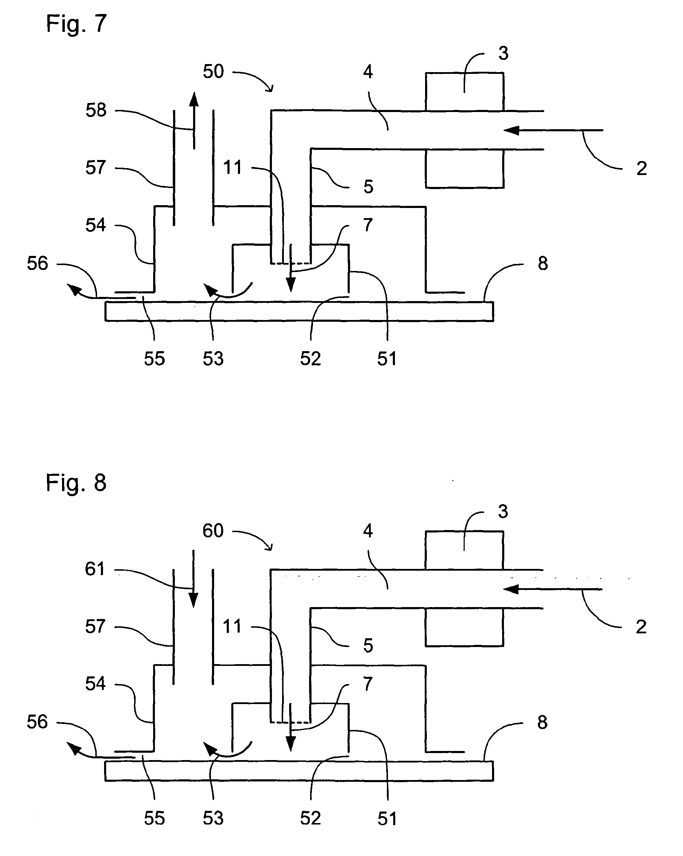

Figure 7 shows a further variant 50 of the present invention, combining the features of the variants shown in Figures 5 and 6. A first hood 54 is provided to minimize the flow of gas 56, such as CO and CO₂, into the evacuated chamber but is not in physical contact with the surface 8 to be cleaned As in the variant shown in Figure 4, the gap 55 between the first hood 54 and the surface 8 to be cleaned is very small and a second tube 57 is provided to exhaust the gas 58, such as CO and CO₂. A second hood 51 attached to the end of the tube 5 has a small gap between it and the surface 8 to restrict the flow of gas 53, such as CO and CO₂, into the space between the first and second hoods 54,51. This variant combines the features of minimizing the flow of gas into the evacuated chamber whilst maintaining a high pressure in the tube 5 to assist in forming a stable plasma region 3, without being in physical contact with the surface 8 to be cleaned.

Figure 8 shows a further variant of the invention The downstream radical source 60 has the same arrangement as that shown in Figure 7 but the second tube 57 is used to provide an inward flow of gas 61, such as N₂, into the first hood 54 instead of extracting gas, such as CO and CO₂. For example, N₂ gas reacts with any remaining oxygen ions in the beam 7 to further reduce the likelihood of ions damaging the surface 8 being cleaned. Other neutralizing gases could be used in place of the N₂ gas.

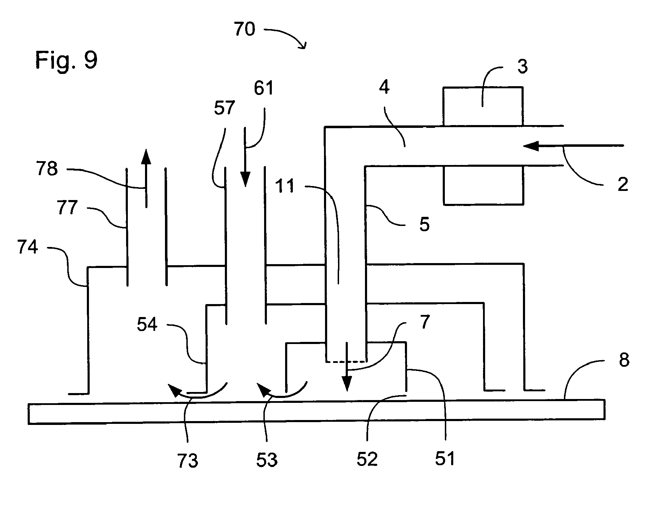

Figure 9 shows a further variant 70 of the invention. The downstream radical source 70 has the same arrangement shown in Figure 8 but a third hood 74 is provided to extract the gas 73 flowing out of the first hood 54. The gas 78 is extracted by means of a third tube 77. This has the advantage of minimizing the load on the system evacuating the main chamber.

It will be appreciated that the variants described with reference to Figures 4 to 9 may also be used with other radical sources and other cleaning techniques such as ozone cleaning and oxygen plasma.

Whilst specific embodiments of the invention have been described above, it will be appreciated that the invention may be practiced otherwise than as described. The description is not intended to limit the invention.

The following are the claims of the parent application as filed and are included as part of the description of the present application.
1. A lithographic projection apparatus comprising:
   - a support structure for supporting patterning means, the patterning means serving to pattern a projection beam according to a desired pattern;
   - a substrate table for holding a substrate;
   - a projection system for projecting the patterned beam onto a target portion of the substrate,
   characterized in that the apparatus further comprises:
   - a downstream radical source, connected to a gas supply, providing a beam of radicals; and
   - means for directing said beam of radicals onto a surface to be cleaned.
2. A lithographic projection apparatus according to claim 1, wherein said beam of radicals contains substantially no ionized particles.
3. A lithographic projection apparatus according to claim 1 or 2, wherein said gas supply supplies at least one of oxygen, hydrogen and fluorine and said downstream radial source correspondingly provides a beam of one of oxygen, hydrogen and fluorine radicals.
4. A lithographic projection apparatus according to claim 1, 2 or 3, wherein said surface to be cleaned is on one of the patterning means, a sensor, a lens, a deflector and a reflector for reflecting one of the projection beam and the patterned beam.
5. A lithographic projection apparatus according to any one of the preceding claims, wherein the position of the downstream radical source is fixed and said means for directing said beam of radicals onto a surface to be cleaned comprises a means for moving the component containing said surface such that the beam of radicals is incident on said surface.
6. A lithographic projection apparatus according to any one of the preceding claims, wherein the downstream radical source comprises at least one of an RF coil, a pair of DC discharge electrodes and a microwave or RF cavity that generates a region of plasma within the flow of gas from the gas supply; the radicals being created in said plasma region.
7. A lithographic projection apparatus according to any one of the preceding claims in which the downstream radical source comprises a high temperature element located within the flow of the gas from the gas supply, the temperature of the high temperature element being sufficient to cause thermal dissociation to create the radicals.
8. A lithographic projection apparatus according to any one of the preceding claims, wherein: the apparatus comprises an evacuated chamber containing the patterning means, the substrate and the projection system; the downstream radical source comprises a tube, the beam of radicals being discharged from an end of said tube; and said end of the tube is located in the evacuated chamber.
9. A lithographic projection apparatus according to claim 8, wherein the region of the downstream radical source in which the radicals are formed is located outside of the evacuated chamber.
10. A lithographic projection apparatus according to any one of the preceding claims, wherein the apparatus comprises two or more downstream radical sources and corresponding beams of radicals for cleaning said surface.
11. A device manufacturing method comprising the steps of
   - providing a substrate that is at least partially covered by a layer of radiation-sensitive material;
   - providing a projection beam of radiation using a radiation system;
   - using patterning means to endow the projection beam with a pattern in its cross-section;
   - projecting the patterned beam of radiation onto a target portion of the layer of radiation-sensitive material,
characterized by:
- providing a flow of gas in a downstream radical source to produce a beam of radicals; and
- directing said beam of radicals onto a surface to be cleaned.

## Claims

1. A lithographic projection apparatus comprising:
- a support structure for supporting patterning means, the patterning means serving to pattern a projection beam according to a desired pattern ;
- a substrate table for holding a substrate;
- a projection system for projecting the patterned beam onto a target portion of the substrate,
**characterized in that** the apparatus further comprises:
- a downstream radical source, connected to a gas supply, providing a beam of radicals; and
- means for directing said beam of radicals onto a surface to be cleaned;
wherein the downstream radical source comprises a high temperature element located within the flow of the gas from the gas supply, the temperature of the high temperature element being sufficient to cause thermal dissociation to create the radicals .

2. A lithographic projection apparatus according to claim 1, wherein said beam of radicals contains substantially no ionized particles.

3. A lithographic projection apparatus according to claim 1 or 2, wherein said gas supply supplies at least one of oxygen, hydrogen and fluorine and said downstream radial source correspondingly provides a beam of one of oxygen, hydrogen and fluorine radicals.

4. A lithographic projection apparatus according to claim 1, 2 or 3, wherein said surface to be cleaned is on one of the patterning means, a sensor, a lens, a deflector and a reflector for reflecting one of the projection beam and the patterned beam.

5. A lithographic projection apparatus according to any one of the preceding claims, wherein the position of the downstream radical source is fixed and said means for directing said beam of radicals onto a surface to be cleaned comprises a means for moving the component containing said surface such that the beam of radicals is incident on said surface.

6. A lithographic projection apparatus according to any one of the preceding claims, wherein: the apparatus comprises an evacuated chamber containing the patterning means, the substrate and the projection system; the downstream radical source comprises a tube, the beam of radicals being discharged from an end of said tube; and said end of the tube is located in the evacuated chamber.

7. A lithographic projection apparatus according to claim 8, wherein the region of the downstream radical source in which the radicals are formed is located outside of the evacuated chamber.

8. A lithographic projection apparatus according to any one of the preceding claims, wherein the apparatus comprises two or more downstream radical sources and corresponding beams of radicals for cleaning said surface.

9. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
**characterized by**:
- providing a flow of gas in a downstream radical source to produce a beam of radicals; and
- directing said beam of radicals onto a surface to be cleaned ;
wherein the downstream radical source comprises a high temperature element located within the flow of the gas from the gas supply, the temperature of the high temperature element being sufficient to cause thermal dissociation to create the radicals.
